Europäisches Patentamt

European Patent Office

Office européen des brevets

(11) Publication number: **0 276 850**
**A2**

# EUROPEAN PATENT APPLICATION

(21) Application number: 88101237.1

(51) Int. Cl.⁴: **H01L 27/08**

(22) Date of filing: 28.01.88

(30) Priority: 28.01.87 JP 17537/87

(43) Date of publication of application:
**03.08.88 Bulletin 88/31**

(84) Designated Contracting States:
**DE FR GB**

(71) Applicant: **KABUSHIKI KAISHA TOSHIBA**
**72, Horikawa-cho Saiwai-ku**
**Kawasaki-shi Kanagawa-ken 210(JP)**

Applicant: **Toshiba Micro-Computer**
**Engineering Corporation**
**25-1, Ekimaehoncho Kawasaki-ku**
**Kawasaki-shi(JP)**

(72) Inventor: **Sueda, Akihiro c/o Patent Division**
**Kabushiki Kaisha Toshiba 1-1 Shibaura**
**1-chome**
**Minato-ku Tokyo 105(JP)**
Inventor: **Motegi, Hiroyuki**
**Daiichi-Koume-So 22-23, Komuka-cho**
**Saiwai-ku Kawasaki-shi(JP)**

(74) Representative: **Ritter und Edler von Fischern,**
**Bernhard,Dipl.-Ing.**
**HOFFMANN - EITLE & PARTNER**
**Arabellastrasse 4**
**D-8000 München 81(DE)**

(54) Semiconductor integrated circuit device with latch up preventing structure.

(57) A semiconductor integrated circuit device according to this invention includes a MOS transistor (13) having source and gate electrodes connected to a first node (N1) to which a first power source potential (VDD) is applied and a drain electrode connected to a second node to which a second power source potential (GND) is applied. A power supply voltage of the semiconductor integrated circuit device is obtained between the first and second nodes (N1, N2).

F I G. 1

## Semiconductor integrated circuit device with latch up preventing structure

This invention relates to a complementary MOS semiconductor integrated circuit device, and more particularly to a semiconductor integrated circuit device which can be made effectively free from latch-up at the time of introduction of surge from a power source terminal.

It is well known that, in complementary MOS semiconductor integrated circuit devices, an internal parasitic thyristor is triggered on by a surge (which is defined as an excessive voltage or current abruptly changing with respect to a signal voltage or current at an ordinary operation level) introduced into a signal output terminal, causing a so-called latch-up phenomenon in which a large current continues to flow between power source terminals.

It is also known that the latch-up phenomenon occurs at the time of generation of surge not only at a signal output terminal but also at a signal input terminal because of, for example, a diode connected to the input terminal for input protection.

The latch-up phenomenon is explained in detail in the following document:
"CMOS TECHNOLOGY OPTIONS"
T. BATRA et al.
American Microsystems, Inc.
3800 Homestead road
Santa Clara, CA 95051
IEEE 1982

In the prior art, in order to prevent generation of the latch-up phenomenon by a surge introduced at the signal input or output terminal, a countermeasure is taken by, for example, enhancing the substrate bias at portions near the signal input and output terminals so that the surge may be absorbed into the power source terminal, thus preventing the introduced surge from being transmitted to internal elements.

However, if the surge is directly applied to the power source terminal, a bipolar transistor constituting the parasitic thyristor tends to be easily turned on. Further, if a surge is applied to the power source which serves as a leakage path for a surge applied to the signal input and output terminals and at the same time an external surge is applied to the input and output terminals, then it will be difficult for the external surge to be absorbed into the power source, causing the parasitic thyristor to be easily turned on. Thus, the latch-up preventing characteristic with respect to the surge introduced at the power source terminal becomes worse than that with respect to the surge introduced at the other terminal. However, in the prior art, since no measure is taken to deal with the surge introduced at the power source terminal, the latch-up phenomenon may easily occur when a surge is introduced via the power source terminal.

As described above, in the prior art, since no measure is taken to deal with an external surge introduced via the power source terminal, the latch-up preventing characteristic with respect to a surge at the power source terminal is bad.

This invention has been made in view of the fact described above, and an object thereof is to provide a semiconductor integrated circuit device having an improved latch-up preventing characteristic with respect to an external surge introduced via a power source.

A semiconductor integrated circuit device according to this invention includes a MOS transistor (13) having source and gate electrodes connected to a first node (N1) to which a first power source potential (VDD) is applied and a drain electrode connected to a second node to which a second power source potential (GND) is applied.

In the semiconductor integrated circuit device, the MOS transistor (13) is kept in the off state in an ordinary operation state in which no surge is generated at the first and second nodes (N1, N2). Therefore, in this case, the MOS transistor (13) is set nonoperative.

When a high voltage surge is generated at the first and second nodes (N1, N2), a potential difference (VN) between the first and second nodes is changed to a value extremely larger than that obtained in the ordinary operation state. In this case, the following operation is effected:

First, when a potential difference (VN) between the gate and drain electrodes of the MOS transistor (13) which are respectively connected to the first and second nodes (N1, N2) exceeds the threshold voltage (VTH) of the MOS transistor (13), the MOS transistor (13) is turned on. This creates a current path from the second node (N2) to the first node (N1), thus permitting a surge applied to one of the nodes (N2) to be absorbed in the other node (N1).

When a voltage between the source and drain electrodes of the MOS transistor (13) rises and exceeds the punch-through voltage of the MOS transistor (13), a punch-through phenomenon occurs in the MOS transistor (13), short-circuiting the source-drain path. This creates a current path between the first and second nodes (N1, N2) so that a surge applied at one of the nodes (e.g., N1) can be absorbed into the other node (N2).

When the source or drain voltage of the MOS transistor (13) rises and if a base current flows into a parasitic PNP or NPN bipolar transistor whose emitter and collector are formed of the source and drain regions of the MOS transistor (13), the parasitic bipolar transistor is turned on. Then, a current path is created between the first and second nodes (N1, N2) due to the collector current flow of the parasitic bipolar transistor, causing a surge applied to one of the first and second nodes (e.g., N2) to be absorbed into the other node (N1). Further, in the case where a large current surge is applied, a collector current flowing in the parasitic bipolar transistor acts as a main surge current.

This invention can be more fully understood from the following detailed description when taken in conjunction with the accompanying drawings, in which:

Fig. 1 is a circuit diagram showing the construction of a first embodiment of this invention;

Figs. 2 and 3 are cross-sectional views for explaining the operation of the circuit of the first embodiment;

Fig. 4 is a cross-sectional view of the circuit of the first embodiment formed with a CMOS inverter circuit;

Fig. 5 is a circuit diagram showing the construction of a second embodiment of this invention;

Figs. 6 and 7 are cross-sectional views for explaining the operation of the circuit of the second embodiment;

Fig. 8 is a cross-sectional view of the circuit of the second embodiment formed with a CMOS inverter circuit;

Fig. 9 is a circuit diagram showing the construction of a third embodiment of this invention;

Figs. 10 and 11 are cross-sectional views of the circuits of the third embodiment;

Fig. 12 is a diagram for illustrating the circuit of the third embodiment;

Figs. 13 and 14 are circuit diagrams used for testing the characteristic of the circuit of the third embodiment;

Fig. 15 is a circuit diagram showing the construction of a fourth embodiment of this invention;

Fig. 16 is a circuit diagram showing the construction of a fifth embodiment of this invention;

Fig. 17 shows an IC pattern of the semiconductor integrated circuit device, in which surge absorption MOS transistor 14 of Fig. 5 is located by a side of power supply pad 12;

Fig. 18 shows an IC pattern of the semiconductor integrated circuit device, in which surge absorption MOS transistor 14 of Fig. 5 is located just under power supply pad 12;

Fig. 19 shows a cross-sectional view of an IC having a the pattern of Fig. 18;

Fig. 20 shows an IC pattern of the semiconductor integrated circuit device, in which surge absorption MOS transistors 13 and 14 of Fig. 9 are respectively placed at two adjacent sides of a rectangular IC chip;

Fig. 21 shows an IC pattern of the semiconductor integrated circuit device, in which surge absorption MOS transistors 13 and 14 of Fig. 9 are respectively placed at two opposite sides of a rectangular IC chip;

Fig. 22 shows an IC pattern of the semiconductor integrated circuit device, in which two-pairs of surge absorption MOS transistor 13A, 14A and 13B, 14B are respectively placed at four sides of a rectangular IC chip;

Fig. 23 shows an IC pattern of the semiconductor integrated circuit device, in which surge absorption MOS transistor 13 and 14 of Fig. 9 are respectively placed at two opposite corners of a rectangular IC chip;

Fig. 24 illustrates how transistor 13 of Fig. 23 can be placed at an open area of the corner of the IC chip;

Fig. 25 shows a configuration of a sixth embodiment of this invention, wherein a transistor structure with no gate is used for surge absorption transistor 14;

Fig. 26 shows a circuit arrangement of a seventh embodiment of this invention, wherein two series-connected MOS transistors 14A and 14B are used for the surge absorption transistor;

Fig. 27 shows a cross-sectional view of an IC having the arrangement of Fig. 26;

Fig. 28 shows a circuit arrangement of an eight embodiment of this invention, wherein dual-gate (floating gate) type MOS transistor 14ʺ is used for the surge absorption transistor; and

Fig. 29 shows a cross-sectional view of an IC having the arrangement of Fig. 28.

There will now be described several embodiments of this invention with reference to the accompanying drawings.

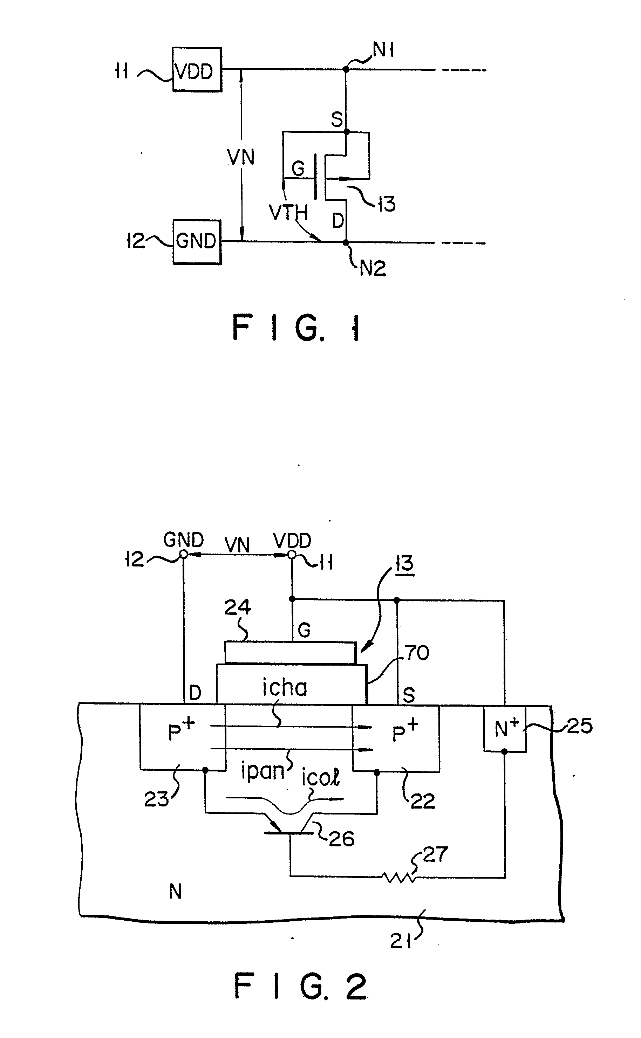

Fig. 1 is a circuit diagram showing the construction of a first embodiment of this invention.

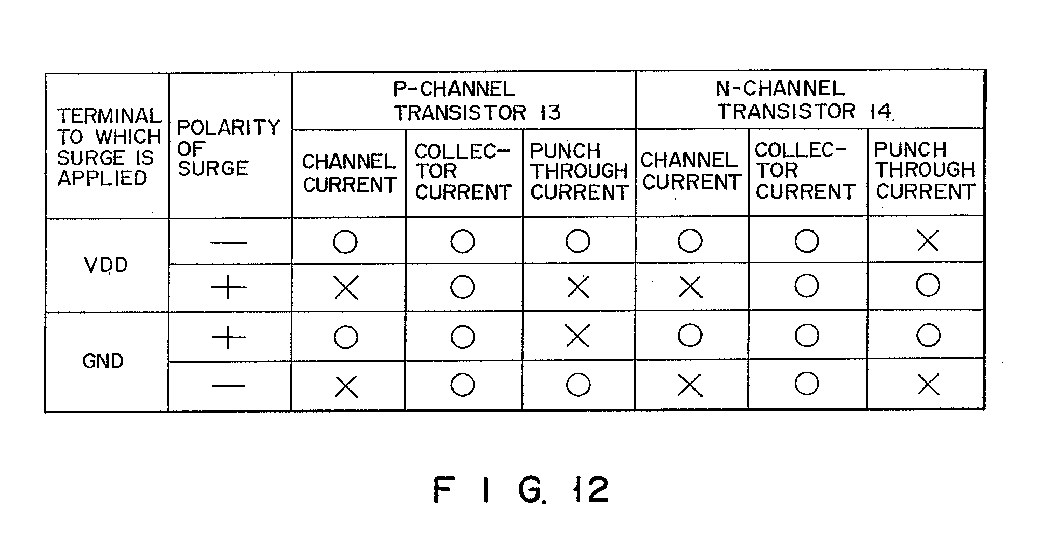

In Fig. 1, 11 denotes an external connection terminal of the IC to which a high potential or VDD potential, for example, +5V, is applied, and 12 denotes an external connection terminal to which a low potential or GND potential (0 V) is applied. In the IC, the source and gate electrodes of enhancement type P channel MOS transistor 13 are connected to VDD terminal 11, and the drain electrode of MOS transistor 13 is connected to GND terminal 12. Further, a substrate or the back gate electrode of MOS transistor 13 is connected to terminal 11.

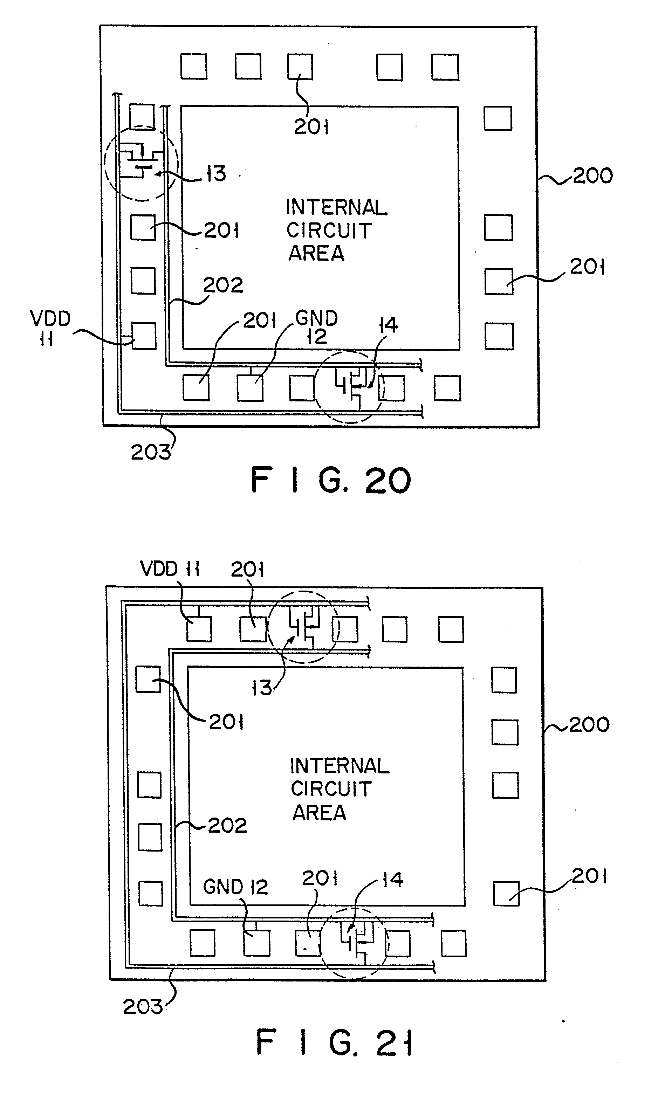

Fig. 2 is a cross-sectional view showing the construction of a device obtained when the Fig. 1 circuit is formed in an integrated circuit form. In Fig. 2, 21 denotes N-type substrate; 22 and 23, $P^+$-type source and drain regions formed in N-type substrate 21; 24, a gate electrode; and 25, an $N^+$-type region formed for substrate bias in order to apply a VDD potential to substrate 21. Gate electrode 24 is placed over a channel between regions 22 and 23, via gate oxide layer (SiO₂) 70.

As shown in Fig. 2, parasitic PNP transistor 26, having source region 22, drain region 23, and substrate 21, respectively serving as a collector, emitter, and base, is formed in substrate 21. Further, parasitic resistor 27 formed of a resistive component of substrate 21 is connected between the base of parasitic PNP transistor 26 and N⁺-type region 25. Whether the collector and emitter of parasitic PNP transistor 26 are respectively formed of regions 22 and 23, or regions 23 and 22, is determined by the relation between potentials of regions 22 and 23.

With this construction, a surge can be applied to terminals 11 and 12 in the following four cases:

(1) in the case where a negative surge voltage is applied to VDD terminal 11,

(2) in the case where a positive surge voltage is applied to GND terminal 12,

(3) in the case where a positive surge voltage is applied to VDD terminal 11, and

(4) in the case where a negative surge voltage is applied to GND terminal 12.

First, the operation in the case (1) will be explained. In this case, when a negative surge voltage is applied to terminal 11, to which a VDD potential of +5V is applied, and lowers the VDD potential, the potential of gate electrode 24 of transistor 13 is lowered with decrease in the VDD potential. Then, when the gate voltage becomes lower than the potential of region 23 by threshold voltage VTH (which is generally -1 V in P channel MOS transistors) of transistor 13, a channel path is created between source and drain regions 22 and 23 in Fig. 2, thereby turning on transistor 13. This causes channel current icha to flow as shown in Fig. 2.

The potential of source region 22 of transistor 13 is also lowered with decrease in the VDD potential. At this time, the potential of substrate 21 will not change so rapidly as the potential of source region 22 due to the presence of resistor 27. When the source potential becomes lower than the potential of substrate 21 by breakdown voltage $V_B$ (which is generally 20 to 30 V) of the PN junction between regions 22 and 21, a breakdown current begins to flow from substrate 21 to source region 22. This causes the potential of substrate 21 to be lowered and the substrate potential tends to approach the source potential which has already been lowered.

When the potential of substrate 21 approaches the source potential and becomes lower than the GND potential by a forward voltage (VF) of the PN junction between regions 23 and 21, a PN junction current begins to flow from drain region 23 to substrate 21. This current is supplied to parasitic PNP transistor 26 as the base current so as to turn on transistor 26, causing collector current icol to flow, as is shown in Fig. 2.

Further, when a potential difference between source and drain regions 22 and 23 of transistor 13 increases with decrease in the VDD potential and exceeds the punch-through voltage (which depends largely on the channel length of MOS transistors and is generally 10 to 20 V) of transistor 13, the path between the source and drain regions is short-circuited, causing punch-through current ipan to flow between source and drain regions 22 and 23, as is shown in Fig. 2.

Next, the operation in the case (2) will be explained. Assume that a positive surge voltage is applied to GND terminal 12 and raises the GND potential. In this case, when the potential of drain region 23 becomes higher than the potential of gate electrode 24 by threshold voltage VTH of P channel MOS transistor 13, transistor 13 is turned on to cause channel current icha to flow as shown in Fig. 2.

When the GND potential rises and becomes higher than the potential of N-type region 21 by forward voltage VF of the PN junction of regions 23 and 21, a PN junction current begins to flow from drain region 23 to substrate 21. The current is supplied as a base current to parasitic PNP transistor 26 to turn on transistor 26, causing collector current icol to flow as shown in Fig. 2.

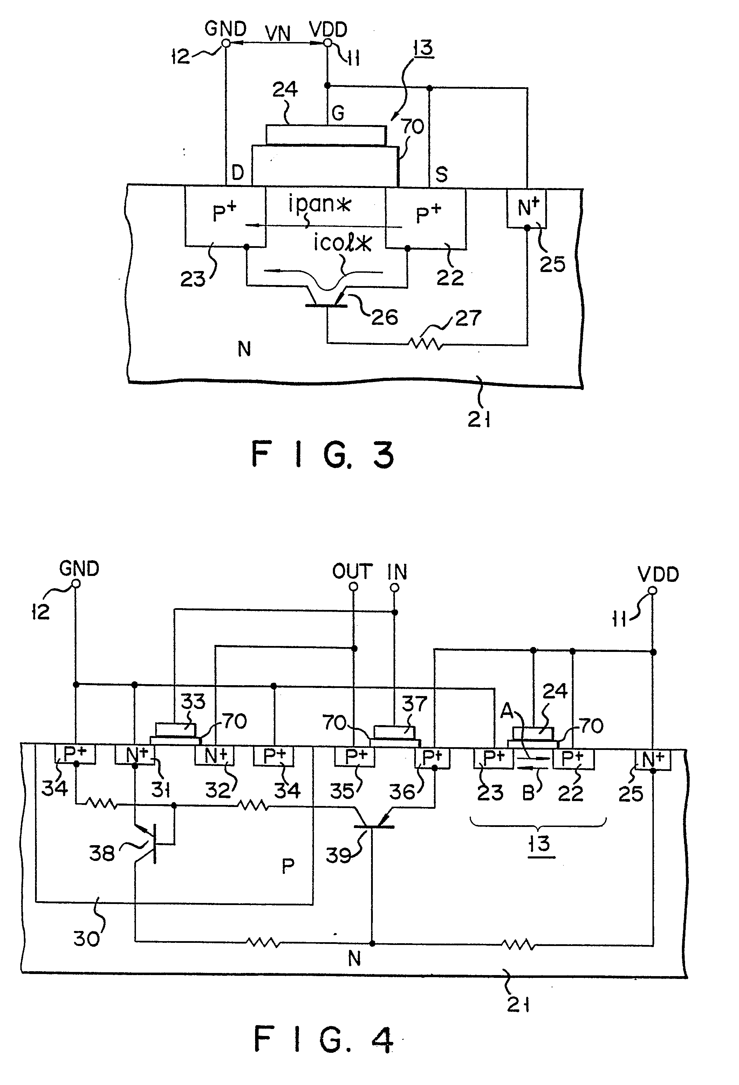

In the case (3) or in the case where a positive surge voltage is applied to VDD terminal 11, the VDD potential rises and then the potential of source region 22 will rise. When the source potential becomes higher than the potential of substrate 21 by forward voltage VF of the PN junction between regions 22 and 21, a current starts to flow from source region 22 to substrate 21. The current is supplied as a base current to parasitic PNP transistor 26 to turn on transistor 26, causing collector current icol* as shown in Fig. 3 in a direction opposite to that of collector current icol in Fig. 2.

In the case (4) or in the case where a negative surge voltage is applied to GND terminal 12, the GND potential falls and the potential of drain region 23 falls. When the GND potential becomes lower than the potential of substrate 21 by the breakdown voltage of the PN junction between regions 23 and 21, a breakdown current starts to flow from substrate 21 to drain region 23. This lowers the potential of substrate 21 and the substrate potential tends to approach the drain potential. When the substrate potential continues to approach the drain potential, the potential of substrate 21 will become lower than the potential of source region 22. Then, when the potential difference between regions 21 and 22 becomes higher than forward voltage VF of the PN junction between regions 22 and 21, a PN junction current starts to flow from source region 22 to substrate 21. This current is supplied as a base current to PNP transistor 26 to turn on transistor 26, causing collector current icol* to flow in a direction as shown in Fig. 3.

Further, in the case (4), when the potential difference between source and drain regions 22 and 23 of transistor 13 becomes larger with decrease in the GND potential and exceeds the punch-through voltage, a path between source and drain regions 22 and 23 is short-circuited, causing punch-through current ipan* to flow between the regions in a direction as shown in Fig. 3.

Thus, when a positive or negative surge voltage is applied to terminal 11 or 12 in the Fig. 1 circuit, various currents icha, icol, icol*, ipan, and ipan* as described above flow between source and drain regions 22 and 23, causing the surge voltage applied to one of terminal 11 and 12 to be absorbed into the other terminal.

Fig. 4 is a cross-sectional view of a semiconductor circuit device having a CMOS inverter circuit together with the circuit of Fig. 1. In Fig. 4, 30 denotes a P-type well region formed in an N-type substrate; 31 and 32, source and drain regions of an N channel MOS transistor constituting the CMOS inverter circuit and formed in P-type well (P-well) region 30; 33, a gate electrode of the transistor; 34, a biasing P$^+$-type region for supplying a GND potential to P-type well region 30; 35 and 36, source and drain regions of a P channel MOS transistor constituting the CMOS inverter circuit and formed in N-type substrate 21; and 37, a gate electrode of the transistor.

As described above, since the CMOS inverter circuit is formed in N-type substrate 21, a parasitic thyristor will be formed to include parasitic NPN transistor 38, having an emitter, base and collector respectively formed of N$^+$-type region 31, P-type well region 30 and N-type substrate 21, and parasitic PNP transistor 39, having an emitter, base and collector respectively formed of P$^+$-type region 36, N-type substrate 21 and P-type well region 30.

When a surge voltage is applied to one of terminals 11 and 12, a current flows in transistor 13 in a direction indicated by an arrow A or B in Fig. 3. This prevents increase in a trigger current (or an emitter current flowing in regions 36 and 31 of PNP transistor 39 and NPN transistor 38 constituting the parasitic thyristor), which may turn on the parasitic thyristor (38 and 39) when a surge voltage is applied. As a result, the parasitic thyristor is prevented from being turned on, improving the latch-up preventing characteristic with respect to a surge voltage applied to power source terminal 11 or 12.

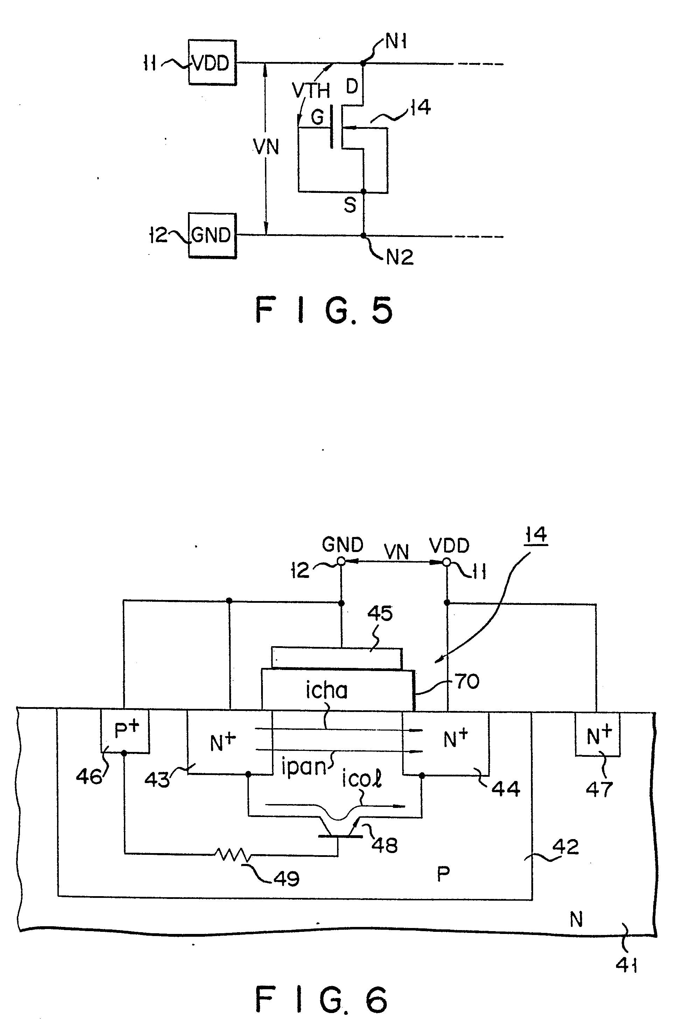

Fig. 5 is a circuit diagram showing the construction of a second embodiment of this invention.

In Fig. 5, 11 and 12 denote external connection terminals to which a VDD potential (high potential) and a GND potential are respectively applied. In the IC, terminal 11 is connected to a drain electrode of enhancement type N channel MOS transistor 14. Source and gate electrodes of transistor 14 are connected to terminal 12. Further, a substrate or the back gate electrode of transistor 13 is also connected to terminal 12.

Fig. 6 is a cross-sectional view showing the construction of an integrated circuit including a P-type well region to form the circuit of Fig. 5. In Fig. 6, 41 denotes an N-type substrate; 42, a P-type well region formed in substrate 41; 43 and 44, N$^+$-type source and drain regions of N channel MOS transistor 14 formed in P-type well region 42; 45, a gate electrode of the transistor; 46, a biasing P$^+$-type region for setting P-type well region 42 to the GND potential; and 47, a biasing N$^+$-type region for setting N-type substrate 41 to the VDD potential.

As shown in Fig. 6, parasitic NPN bipolar transistor 48 having a collector, emitter and base formed of N$^+$-type source and drain regions 43 and 44 and P-type well region 42 is created in P-type well region 42. Further, parasitic resistor 49 formed of resistance component of P-type well region 42 is connected between region 46 and the base of parasitic bipolar transistor 48. In the case, whether the emitter and collector of parasitic NPN transistor 48 are respectively formed of regions 43 and 44, or regions 44 and 43 is determined according to the potential relation between regions 43 and 44.

With the circuit of this construction, a surge voltage is applied to terminal 11 or 12 only in the cases (1) to (4) as described before.

In the case (1) or in the case where a negative surge voltage is applied to VDD terminal 11 and the VDD potential is lowered, the potential of drain region 44 of transistor 14 is lowered with decrease in the VDD potential. Then, when the drain potential becomes lower than the gate potential by threshold voltage VTH (which is generally +1 V in N channel MOS transistors) of transistor 14, a channel path is created between source and drain regions 43 and 44 in Fig. 6, turning on transistor 14. This causes channel current icha to flow as shown in Fig. 6.

When the potential of drain region 44 of transistor 14 is lowered and becomes lower than the potential of P-type well region 42 by a forward voltage (VF) of the PN junction between regions 42 and 44, a PN junction current begins to flow from P-type well region 42 to drain region 44. The current is supplied to parasitic bipolar transistor 48 as the base current to turn on transistor 48, causing collector current icol to flow as shown in Fig. 6.

In the case (2) or in the case where a positive surge voltage is applied to GND terminal 12 and the GND potential rises, the potential of gate electrode 45 rises. When the gate potential becomes higher than the potential of drain region 44 by threshold voltage VTH of N channel MOS transistor 14, transistor 14 is turned on to cause channel current icha to flow as shown in Fig. 6.

When the GND potential rises and the potential of source region 43 becomes higher than the potential of P-type well region 42 by breakdown voltage VB of the PN junction between regions 42 and 43, a breakdown current begins to flow from souce region 43 to P-type well region 42. The current flow causes the potential of P-type well region 42 to be raised. When the potential of P-type well region 42 becomes higher than potential VDD of drain region 44 by forward voltage VF of the PN junction between regions 42 and 44, a PN junction current starts to flow from P-type well region 42 to drain region 44. The current is supplied as a base current to parasitic NPN transistor 48 to turn on transistor 48, causing collector current icol to flow as shown in Fig. 6.

Further, when the potential of source region 43 rises and a potential difference between potentials of source and drain regions 43 and 44 exceeds the punch-through voltage, the source-drain path of transistor 14 is short-circuited, causing a punch-through cArrent ipan to flow between regions 43 and 44 as shown in Fig. 6.

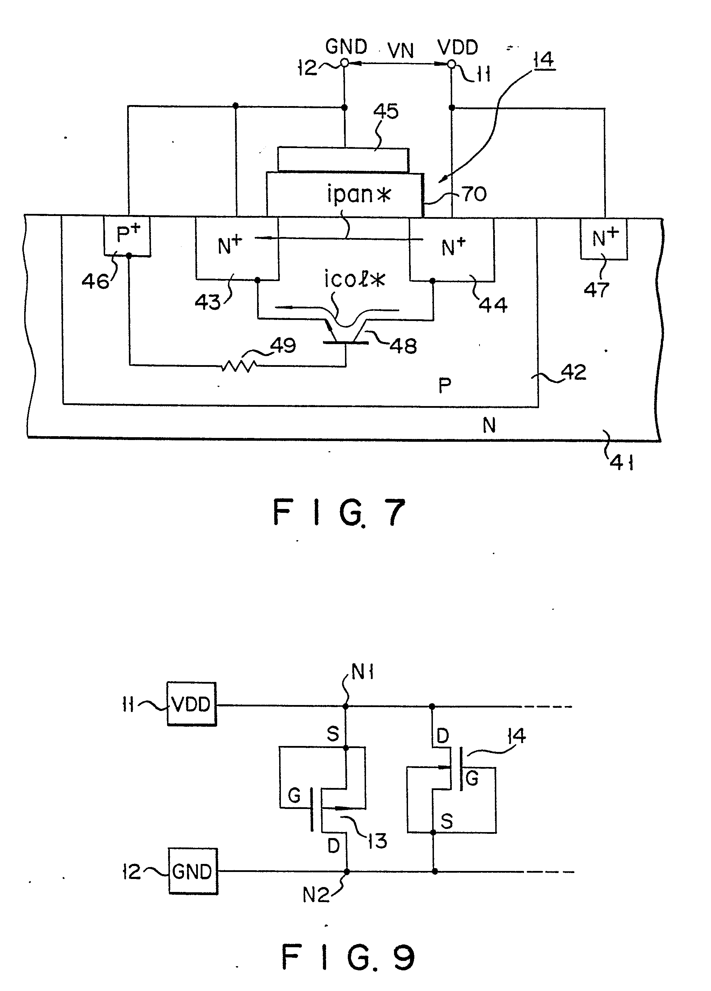

In the case (3) or in the case where a positive surge voltage is applied to VDD terminal 11, the VDD potential rises and then the potential of drain region 44 will rise. When the drain potential becomes higher than the potential of P-type well region 42 by breakdown voltage VBE of the PN junction between regions 42 and 44, a breakdown current starts to flow from drain region 44 to P-type well region 42. The current flow raises the potential of P-type well region 42. When the potential of P-type well region 42 becomes higher than potential GND of source region 43 by forward voltage VF of the PN junction between regions 42 and 43, a PN junction current starts to flow from P-type well region 42 to source region 43. The current is supplied as a base current to parasitic NPN transistor 48 to turn on transistor 48, causing collector current icol* as shown in Fig. 7 in a direction opposite to that of collector current icol in Fig. 6.

Further, when the drain potential rises and a potential difference between potentials of source and drain regions 43 and 44 exceeds the punch-through voltage, the source-drain path of transistor 14 is short-circuited, causing a punch-through current ipan* to flow between regions 43 and 44 as shown in Fig. 7.

In the case (4) or in the case where a negative surge voltage is applied to GND terminal 12, the GND potential falls and the potential of source region 43 falls. When the source potential becomes lower than the potential of P-type well region 42 by forward voltage VF of the PN junction between regions 42 and 43, a forward current starts to flow from P-type well region 42 to source region 43 via the PN junction. The current is supplied as a base current to NPN transistor 48 to turn on transistor 48, causing collector current icol* to flow in a direction as shown in Fig. 7.

As described above, when a positive or negative surge voltage is applied to terminal 11 or 12 in the Fig. 5 circuit, various currents icha, icol, icol*, ipan, and ipan* flow between source and drain regions 43 and 44, causing the surge voltage applied to one of terminals 11 and 12 to be absorbed into the other terminal.

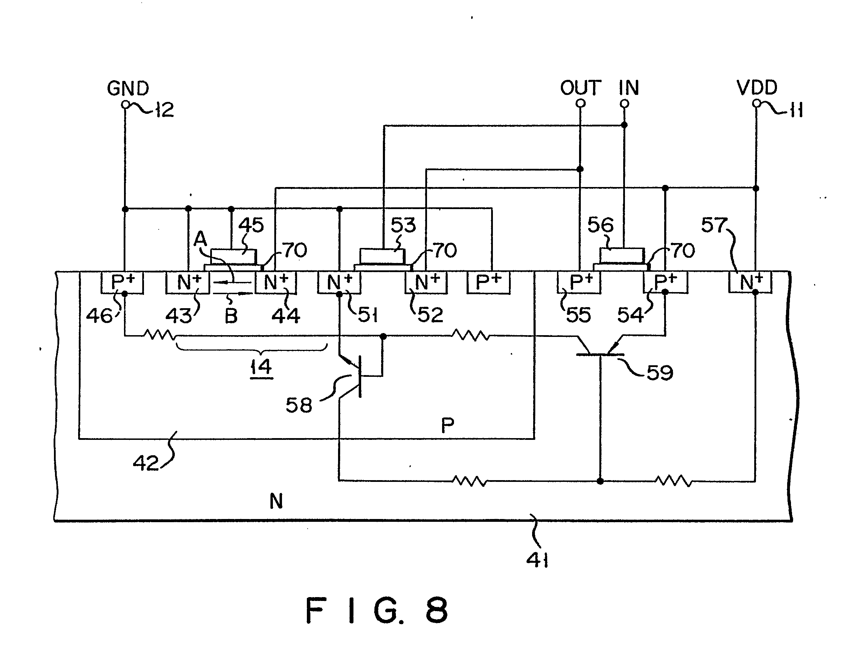

Fig. 8 is a cross-sectional view of a semiconductor circuit device having a CMOS inverter circuit together with the circuit of the above embodiment. In Fig. 8, 51 and 52 denote source and drain regions of an N channel MOS transistor constituting the CMOS inverter circuit and formed in P-type well region 42; 53, a gate electrode of the transistor; 54 and 55, source and drain regions of a P channel MOS transistor constituting the CMOS inverter circuit and formed in N-type substrate 41; 56, a gate electrode of the transistor; and 57, a biasing $N^+$-type region for setting N-type substrate 41 to the VDD potential.

As described above, since the CMOS inverter circuit is formed in N-type substrate 41, a parasitic thyristor will be formed to include parasitic NPN transistor 58, having an emitter, base and collector respectively formed of $N^+$-type region 51, P-type well region 42 and N-type substrate 41, and parasitic PNP transistor 59, having an emitter, base and collector respectively formed of $P^+$-type region 54, N-type substrate 41 and P-type well region 42.

When a surge voltage is applied to one of terminals 11 and 12, a current flows in transistor 14 in a direction indicated by an arrow A or B in Fig. 8. This prevents increase in a trigger current (or an emitter current flowing in regions 54 and 51 of PNP transistor 59 and NPN transistor 58 constituting the parasitic thyristor) which may turn on the parasitic thyristor (38 and 39) when a surge voltage is applied. As a result, the parasitic thyristor is prevented from being turned on, improving the latch-up preventing characteristic with respect to a surge voltage applied to power source terminal 11 or 12.

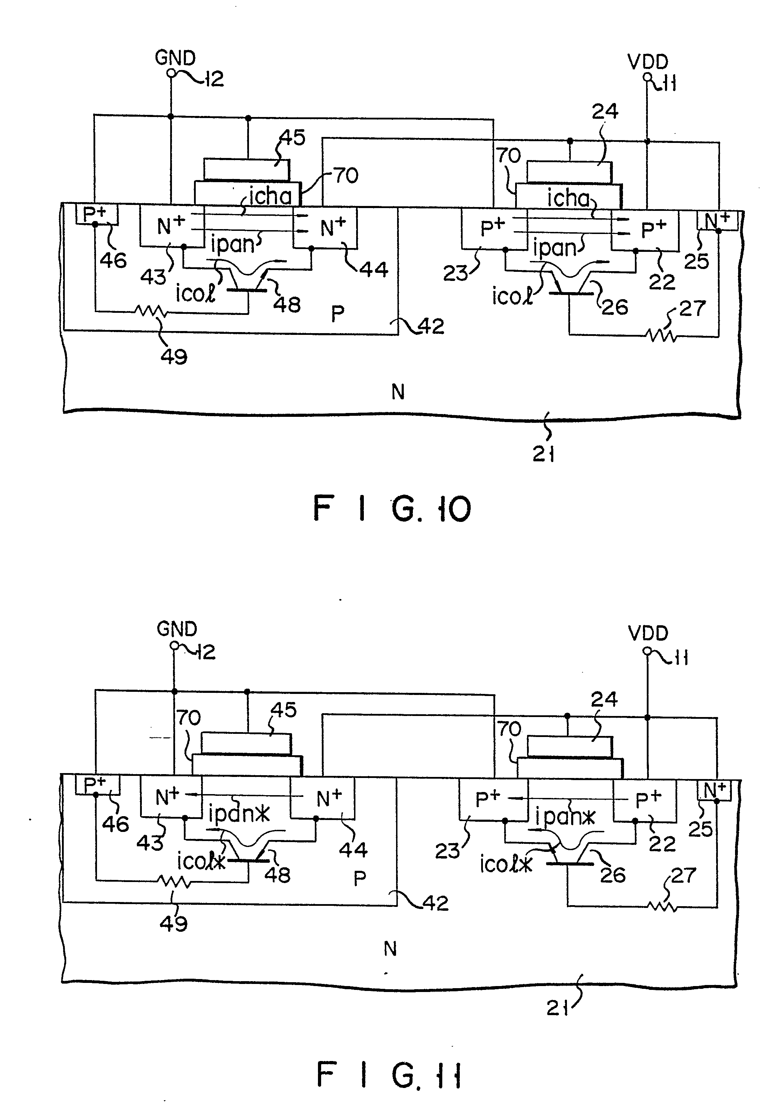

Fig. 9 is a circuit diagram showing the construction of a third embodiment of this invention. In the circuit of this embodiment, P channel MOS transistor 13 in the circuit of the first embodiment and N channel MOS transistor 14 in the circuit of the second embodiment are used.

Figs. 10 and 11 are cross-sectional views showing the construction of a device obtained when the Fig. 9 circuit is formed in the form of integrated circuit utilizing a P-type well region. Fig. 10 shows the cases (1) and (2), and Fig. 11 shows the cases (3) and (4).

In the figures, 21 denotes N-type substrate; 22 and 23, $P^+$-type source and drain regions formed in N-type substrate 21; 24, an gate electrode; and 25, an $N^+$-type region for applying a VDD potential to substrate 21. As shown in Fig. 9, parasitic PNP transistor 26 is formed to have source and drain regions 22 and 23 and substrate 21 as a collector, emitter and base. Further, 27 denotes a parasitic resistor; 42, P-type well region formed in substrate 21; 43 and 44, $N^+$-type source and drain regions of N channel MOS transistor 14 formed in P-type well region 42; 45, a gate electrode of the transistor; 46, a biasing $P^+$-type region for setting P-type well region 42 to the GND potential; 48, a parasitic NPN bipolar transistor having a collector, emitter and base formed of $N^+$-type source and drain regions 43 and 44 and P-type well region 42; and 49, a parasitic resistor formed of resistance component of P-type well region 42.

In the circuit of this construction, the ability of absorbing the surge into the power source terminal can be more enhanced in comparison with the circuits of the first and second embodiments, because two current paths are formed on both the N and P channel circuits between terminals 11 and 12. Therefore, the surge can be absorbed into the power source in a brief time, thereby greatly improving the latch-up preventing characteristic.

Fig. 12 shows currents flowing in transistors 13 and 14 in the circuit of the embodiment in Fig. 9 when a surge is applied to terminal 11 or 12. In Fig. 12, "o" mark indicates that a current flows, and "x" mark indicates that no current flows. In the case where a negative surge is applied to the VDD terminal, a channel current, collector current and punch-through current flow in P channel MOS transistor 13, and a channel current and collector current flow in N channel MOS transistor 14.

In the case where a positive surge is applied to the VDD terminal, a collector current flows in P channel MOS transistor 13, and a collector current and punch-through current flow in N channel MOS transistor 14.

In the case where a positive surge is applied to the GND terminal, a channel current and collector current flow in P channel MOS transistor 13, and a channel current, collector current and punch-through current flow in N channel MOS transistor 14.

In the case where a negative surge is applied to the GND terminal, a collector current and punch-through current flow in P channel MOS 13, and a collector current flows in N channel MOS transistor 14.

As is clearly seen from Fig. 12, in the case where, for example, a negative surge is applied to GND terminal 12, only a collector current flows in N channel MOS transistor 14 in the embodiment of Fig. 5 in which only N channel MOS transistor 14 is formed. However, in this embodiment, a collector current and punch-through current flow in P channel MOS transistor 13 and thus a current on the P channel circuit side additionally flows, permitting a surge to be rapidly absorbed into the power source. Therefore, in the circuit of this embodiment, the latch-up preventing characteristic can be significantly improved in comparison with the case where only P channel MOS transistor 13 or N channel MOS transistor 14 is used.

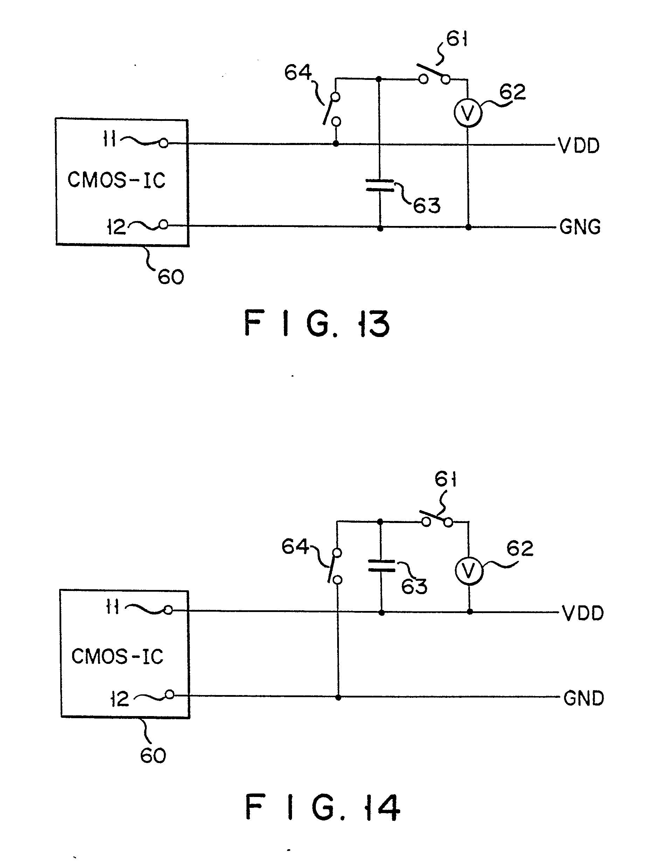

Figs. 13 and 14 are circuit diagrams showing the constructions of test circuits for checking whether or not the latch-up phenomenon occurs when a surge is applied to the power source of a CMOS-IC according to this invention in which P channel MOS transistor 13 and N channel MOS transistor 14 are both formed as shown in Fig. 9.

Fig. 13 shows the test circuit for applying a surge to the VDD terminal, and VDD and GND potentials are externally supplied to terminals 11 and 12 of CMOS-IC 60, respectively. In this circuit, switch 61 is first closed to charge capacitor 63 with a capacitance of, for example, 200 pF by means of power source 62. Then, switch 61 is opened and switch 64 is closed to discharge charges in capacitor 63 to terminal 11, thus applying a surge to terminal 11. If, at this time, the latch-up phenomenon occurs, the voltage of power source 62 can be regarded as a surge voltage which has caused the latch-up phenomenon.

Fig. 14 shows the test circuit for applying a surge to the GND terminal. In this circuit, charges stored in capacitor 63 is applied to terminal 12 by closing switch 64, thus making it possible to measure a voltage at terminal 12 which causes the latch-up phenomenon.

The prior art IC in which protection transistor 13 or 14 used in this invention is not connected between terminals 11 and 12 has been tested by using the test circuit as described above. The test result shows that a latch-up phenomenon occurs when the stored voltage of capacitor 63 is lower than 50 V (positive surge) or higher than -50 V (negative surge) in the case of the test circuit of Fig. 13 and also when the stored voltage is lower than 50 V or higher than -50 V in the case of the test circuit of Fig. 14.

In contrast, in the case where the IC of this invention has been tested, it has indicated that no latch-up phenomenon occurs when the stored voltage of capacitor 63 is within 500 V and -500 V in the case of the test circuit of Fig. 13, and also when the stored voltage is within 500 V and -500 V in the case of the test circuit of Fig. 14. This result shows that the latch-up preventing characteristic of the circuit of this invention with respect to a surge voltage applied to the power source terminal is significantly improved.

This invention is not limited to the embodiments described above and can be applied to various modifications of ICs. For example, in the above embodiments, the IC is formed to have two power source terminals, but this invention can be applied to CMOS-ICs having three or more power source terminals. In this case, the latch-up preventing characteristic with respect to a surge applied to the power source terminal can be improved by connecting at least one of P and N channel MOS transistors between a pair of power source terminals.

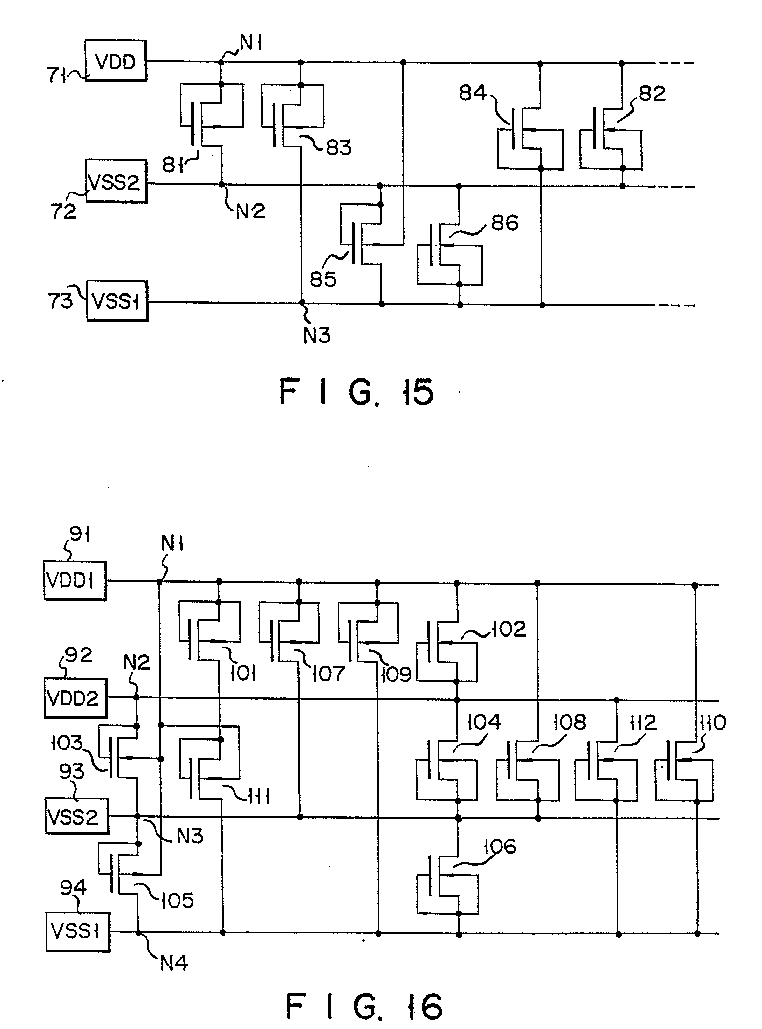

Fig. 15 shows a fourth embodiment of this invention. In Fig. 15, an IC is formed to have three power source terminals which are set at a high potential or VDD potential, low potential or Vss1 potential, and semi-low potential or Vss2 potential.

P and N channel MOS transistors 81 and 82 are connected between external connection terminal 71 to which a high potential or VDD potential is applied and external connection terminal 72 to which a semi-low potential or Vss2 potential is applied, P and N channel MOS transistors 83 and 84 are connected between external connection terminal 71 and external connection terminal 73 to which a low potential or Vss1 potential is applied, and P and N channel MOS transistors 85 and 86 are connected between external connection terminals 72 and 73. The gate electrodes of the MOS transistors are connected to be set at a preset power source potential level which keeps the MOS transistors off when the terminals are set at preset power source potential levels.

In the circuit of this embodiment, it is possible to connect only one of P and N channel MOS transistors between the paired terminals. However, it is preferable to use both of them in order to increase the number of current paths through which a surge can pass.

Fig. 16 is a circuit diagram showing the construction of a fifth embodiment of this invention. In Fig. 16, an IC is formed to have four power source terminals which are respectively set at a high potential or VDD1 potential, semi-high potential or VDD2 potential, low potential or Vss1 potential, and semi-low potential or Vss1 potential.

P and N channel MOS transistors 101 and 102 are connected between external connection terminal 91 to which a VDD1 potential is applied and external connection terminal 92 to which a VDD2 potential is applied. P and N channel MOS transistors 103 and 104 are connected between external connection terminal 92 and external connection terminal 93 to which a Vss2 potential is applied. P and N channel MOS transistors 105 and 106 are connected between external connection terminal 93 and external connection terminal 94 to which a low potential or Vss2 potential is applied. P and N channel MOS transistors 107 and 108 are connected between external connection terminals 91 and 93.

Further, P and N channel MOS transistors 109 and 110 are connected between external connection terminals 91 and 94. P and N channel MOS transistors 111 and 112 are connected between external connection terminals 92 and 94. Also, in this case, the gate electrodes of the MOS transistors are connected to be set at a preset power source potential level which keeps the MOS transistors off when the terminals are set at preset power source potential levels.

In the circuit of this embodiment of Fig. 16, it is possible to connect only one of P and N channel MOS transistors between the paired terminals, but it is preferable to use both of them.

As described above, according to this invention, it is possible to provide a semiconductor integrated circuit device which can improve the latch-up preventing characteristic with respect to an external surge applied to a power source terminal.

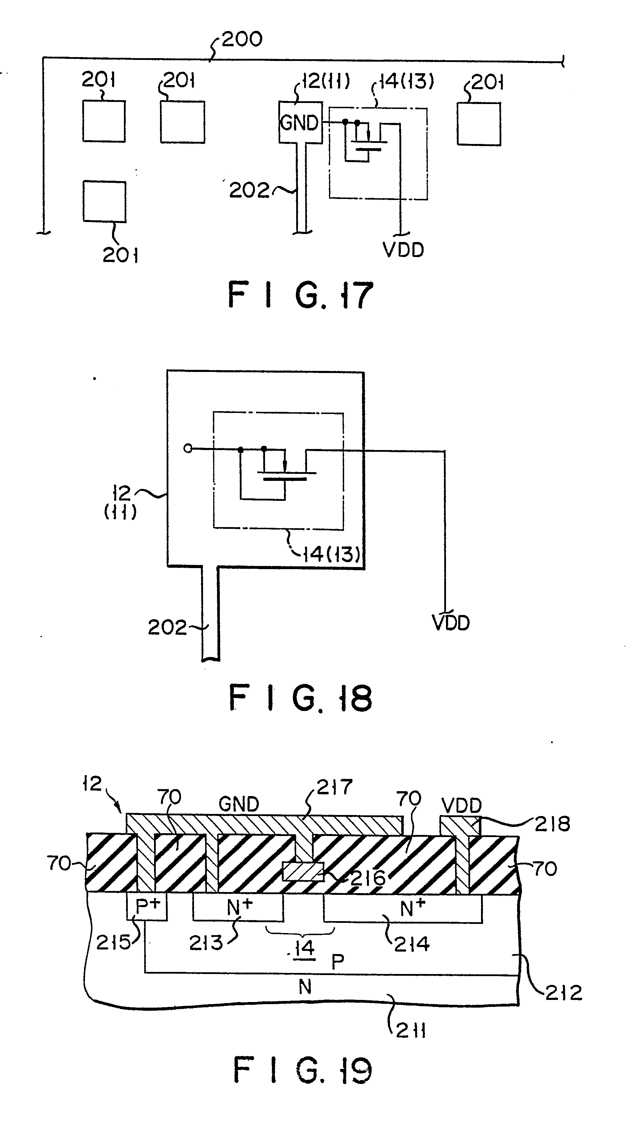

Fig. 17 shows the case in which surge absorbing MOS transistor 14 in Fig. 5 or MOS transistor 13 in Fig. 1 is formed adjacent to power source pad 12 or 11 among a number of pads 201 which are arranged on the peripheral portion of IC chip 200. When MOS transistor 14 is placed adjacent to pad 12 in this way, a surge current introduced into pad 12 can be bypassed via MOS transistor 14 before it is fed into wiring 202 in the IC. This effectively protects the operation of the internal circuit (not shown) connected to IC internal wiring 202 from being affected by the surge current.

Fig. 18 shows the case in which surge absorbing MOS transistor 14 in Fig. 5 or MOS transistor 13 in Fig. 1 is formed under power source pad 12 or 11 among a number of pads 201 which are arranged on the peripheral portion of IC chip 200. When MOS transistor 14 is placed under pad 12 in this way, a surge current introduced into pad 12 can be bypassed via MOS transistor 14 before it is fed into the wiring in the IC as in the same manner as described in the embodiment of Fig. 17. This effectively protects the internal circuit of the IC from being affected by the surge current.

Fig. 19 is a cross-sectional view of the IC having the pattern shown in Fig. 18. $N^+$-type source region 213 and $N^+$-type drain region 214 are formed in P-well 212 which is formed in substrate 211. Gate electrode 216 of MOS transistor 14 is formed in field oxide film 70. Film 70 is formed on the channel which lies between regions 213 and 214. $P^+$-type region 215 for biasing the P-well is formed in the boundary between N-type substrate 211 and P-well 212. Regions 213 and 215 and electrode 216 are connected to each other via metal wiring layer 217. Region 214 is connected to metal wiring layer 218 for the VDD power source. In this case, part of power source pad 12 constitutes wiring layer 217.

With the construction shown in Figs. 18 and 19, since transistor 14 is formed directly under pad 12, the area for forming transistor 14 or 13 on the IC chip can be reduced in comparison with the case of Fig. 17.

With the construction of combination of surge absorbing MOS transistors 13 and 14, a parasitic thyristor is formed by $P^+$-type region 22, N-type substrate 21, P-well 42, and $N^+$-type region 43 in Fig. 10, in the order of P, N, P, and N. The purpose of providing transistors 13 and 14 is to prevent latching-up of parasitic thyristor(s) caused by a surge voltage applied to a power supply circuit, which parasitic thyristor(s) is unintentionally formed at anywhere of the semiconductor integrated circuit. This purpose cannot be achieved if the parasitic thyristor formed of transistors 13 and 14 is inadvertently turned on. In any case, transistors 13 and 14 must operate such that they bypass a surge current supplied to one power supply circuit to another power supply circuit.

In the following, constructions for preventing formation of the parasitic thyristor of transistors 13 and 14 will be explained:

Fig. 20 shows the case in which surge absorbing MOS transistors 13 and 14 of Fig. 9 are arranged on two adjacent sides of IC chip 200. In Fig. 20, 201 denotes a signal pad; 202, a wiring pattern of ground circuit GND; and 203, a wiring pattern of power source circuit VDD. In the case where MOS transistors 13 and 14 are separately arranged in this way, $P^+$-type region 22 of Fig. 10 is formed in a position far away from P-well 42. Then, the base region of a PNP transistor, which is contained in the PNPN structure of a parasitic thyristor formed by a combination of transistors 13 and 14, is physically expanded, or the distance between N region 22 and P-well 42 is materially elongated, so that current amplification factor hfe of said PNP transistor is suppressed to a sufficiently low value, to thereby reduce the tendency of occurring the latching-up. The primary purpose of transistors 13 and 14, i.e., the purpose of bypassing a surge current from one power supply circuit to another power supply circuit, can thus be achieved.

Fig. 21 shows the case in which surge absorbing MOS transistors 13 and 14 of Fig. 9 are arranged on two opposite sides of IC chip 200. In this case, $P^+$-type region 22 is formed in a position far away from P-well 42, to thereby prevent a parasitic thyristor, formed in the combined structure of MOS transistors 13 and 14, from being turned on.

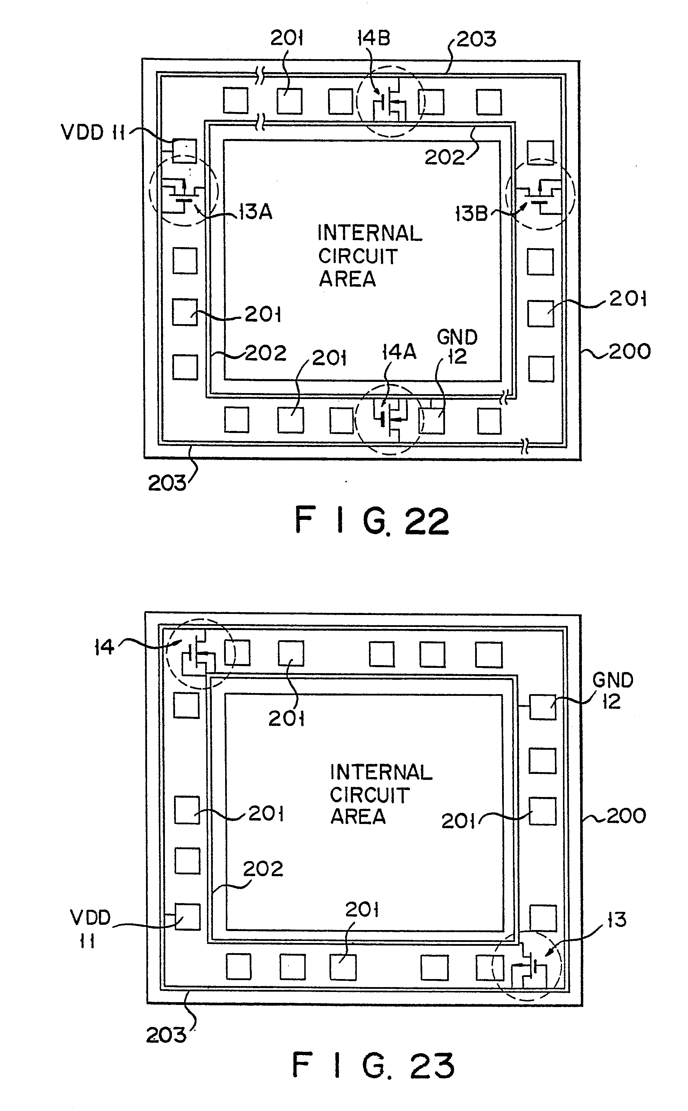

Fig. 22 shows the case in which two pairs of surge absorbing MOS transistors 13A, 14A and 13B, 14B are respectively arranged on two opposite sides of IC chip 200. With this construction, $P^+$-type region 22 of each pair of the surge absorbing MOS transistors is formed in a position far away from P-well 42 of each pair of the MOS transistors, to thereby prevent a parasitic thyristor, formed in the combined structures of MOS transistors 13A, 14A and 13B, 14B, from being turned on.

Fig. 23 shows the case in which surge absorbing MOS transistors 13 and 14 of Fig. 9 are arranged on two opposite corners of IC chip 200. With this construction, $P^+$-type region 22 is formed in a position far away from P-well 42, thus preventing a parasitic thyristor, formed in the combined structure of MOS transistors 13 and 14, from being turned on. Incidentally, it is also possible to form two MOS transistors 13 and 14 on the right and left corners of one side of IC chip 200.

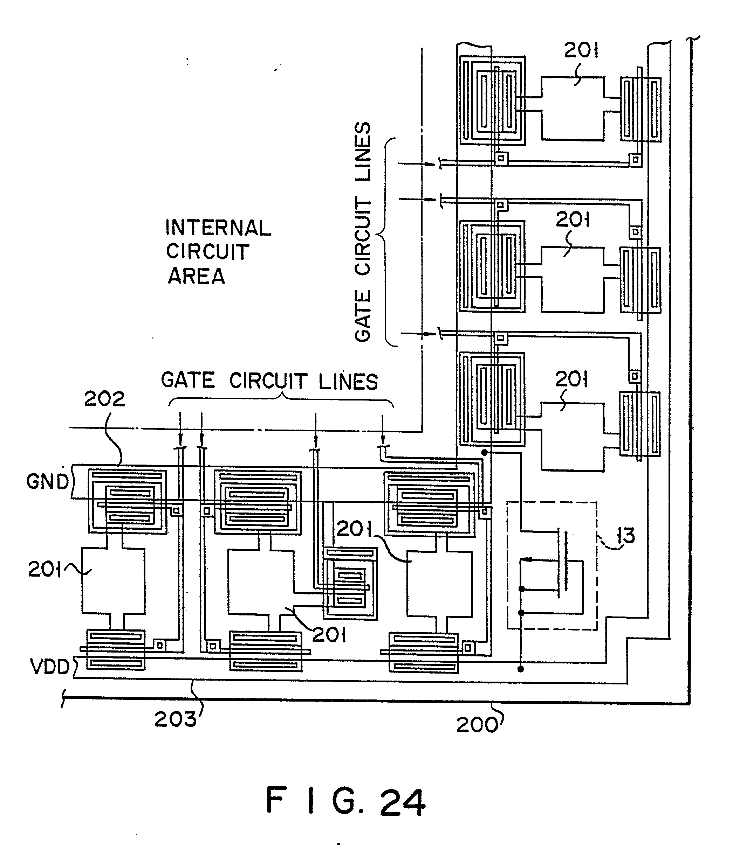

In practice, it is rare that active elements in the body of the IC circuit are formed at the corners of IC chip 200, and in general, a certain space is provided at the corner as is shown in Fig. 24. Fig. 23 shows the construction in which surge absorbing MOS transistor 13 (and 14) is formed, using this corner space.

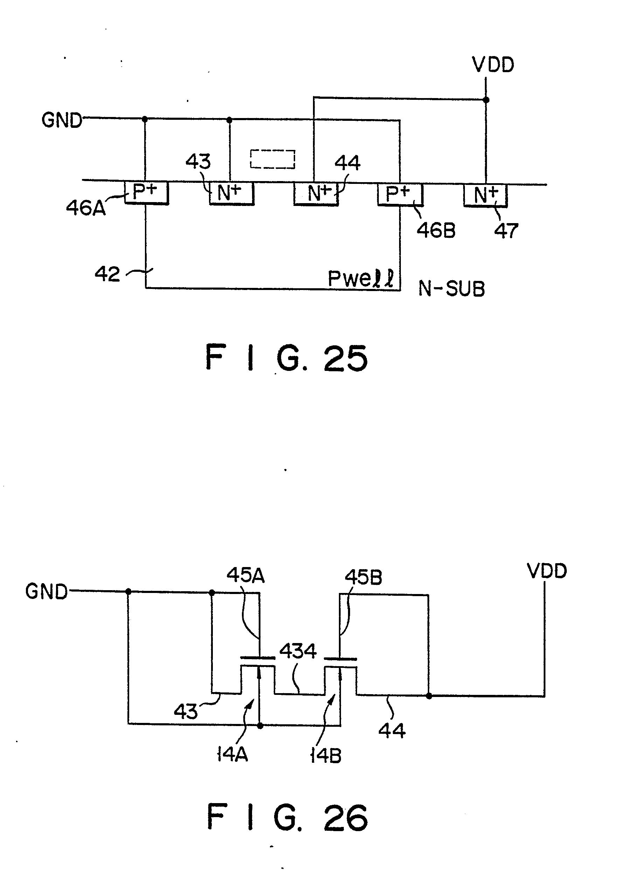

Fig. 25 shows a sixth embodiment of this invention. In the sixth embodiment, a bipolar transistor structure is used as the surge absorbing element instead of the MOS transistor structure. The cross-sectional structure of Fig. 25 corresponds to that obtained by eliminating gate electrode 45 from the Fig. 6 structure. (The crosssectional structure attained when a surge is applied to the VDD terminal corresponds to that obtained by eliminating gate electrode 45 from the Fig. 7 structure.)

In Fig. 25 structure, since no gate electrode is formed, a channel current in Fig. 12 will not flow and only a collector current and punch-through current will flow at the time of surge absorption.

Fig. 26 shows a seventh embodiment of this invention. In the seventh embodiment, the surge absorbing element is formed of two serially connected MOS transistors 14A and 14B.

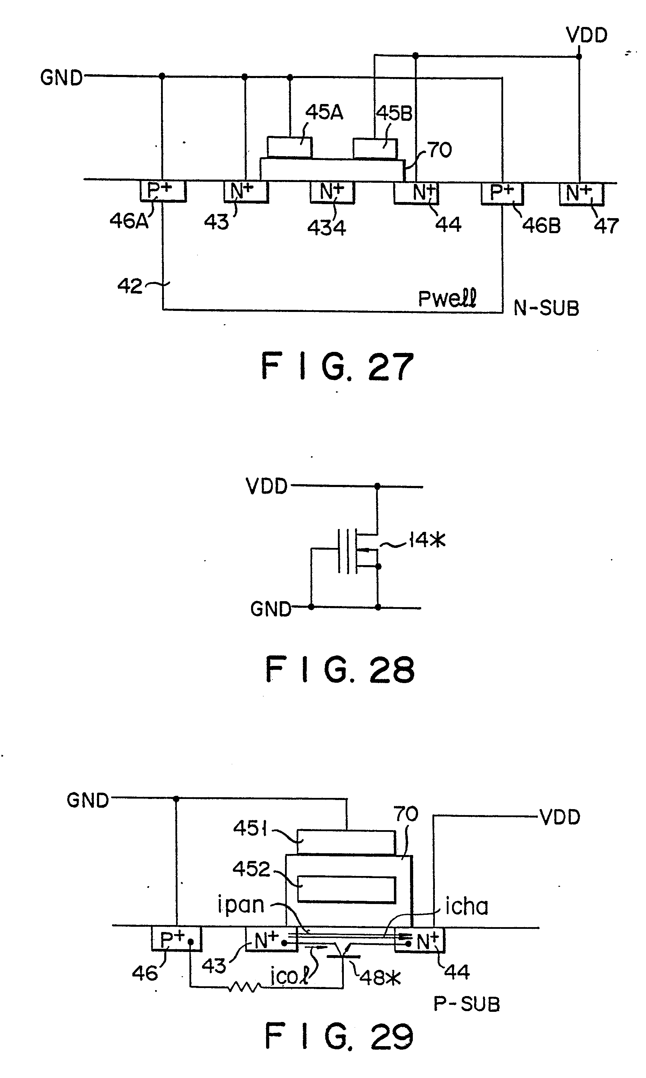

Fig. 27 is a cross-sectional view showing the construction of the embodiment of Fig. 26 which is formed in the form of IC. $N^+$-type regions 43, 44 and 434 are formed in P-well 42 which is formed in an N-substrate. Gate electrodes 45A and 45B of NMOS transistors 14A and 14B are respectively formed over channels between regions 43 and 434 and between 434 and 44. $P^+$-type regions 46A and 46B are formed in the boundary between the N-type substrate and P-well 42. Regions 43, 46A, and 46B and electrode 45A are connected to the ground circuit GND, and regions 44 and 47 and electrode 45B are connected to the VDD power source circuit.

In the Fig. 27 structure, a surge can be absorbed by causing a surge current, fed into the GND circuit (or VDD circuit), to flow into the VDD circuit (or GND circuit), via the two series-connected MOS transistor structures.

Fig. 28 shows an eighth embodiment of this invention. In the eighth embodiment, the surge absorbing element is formed of a double-gate MOS transistor 14*. Such a MOS transistor of the double-gate structure is used in an erasable programmable ROM (EPROM), electrically erasable programmable ROM (EEPROM) or the like.

Fig. 29 is a cross-sectional view of an IC having the EPROM structure as shown in Fig. 28. Even if MOS transistor 14* of the EPROM structure is formed between the GND circuit and VDD circuit in this way, when the same surge application condition as in the case of Fig. 6 is considered, a channel current caused by gate electrode 451 flows in addition to punch-through current ipan and collector current icol of bipolar transistor 48*. The magnitude of a channel current flowing in Fig. 29 may differ from that of Fig. 6 due to the presence of floating gate 452, but a surge absorbing effect as large as that in Fig. 6 can be attained in the structure of Fig. 29.

As described above, according to this invention, a semiconductor integrated circuit device can be obtained which can improve the latch-up preventing characteristic with respect to a surge introduced via the power source terminal.

## Claims

1. A semiconductor integrated circuit device comprising:

a semiconductor region (21 or 42) of a first conductivity type (N or P);

a source region (22 or 43) of a second conductivity type (P or N) formed in said semiconductor region (21 or 42) and directly connected to a first power source circuit (VDD or GND) of the semiconductor integrated circuit device;

a drain region (23 or 43) of the second conductivity type (P or N) formed adjacent to said source region (22 or 43) in said semiconductor region (21 or 42) and directly connected to a second power source circuit (GND or VDD) of the semiconductor integrated circuit device; and

means (25, 27 or 46, 49) for connecting said first power source circuit (VDD or GND) to a base portion of a bipolar transistor structure (26 or 48) formed of said semiconductor region (21 or 42), source region (22 or 43), and drain region (23 or 44).

2. A device according to claim 1, further comprising:

a gate electrode (24 or 45) arranged over a channel region formed between said source region (22 or 43) and drain region (23 or 44) and connected to said first power source circuit (VDD or GND).

3. A device according to claim 1, characterized in that said bipolar transistor structure (26 or 48) is formed near the edge portion of a semiconductor chip (200) on which the semiconductor integrated circuit device is formed.

4. A device according to claim 1, characterized in that said bipolar transistor structure (26 or 48) is formed on the corner of a semiconductor chip (200) on which the semiconductor integrated circuit device is formed.

5. A device according to claim 1, characterized in that said bipolar transistor structure (48) is arranged by the side of a pad (12) connected to said first power source circuit (GND) of the semiconductor integrated circuit device.

6. A device according to claim 1, characterized in that the bipolar transistor structure (26) is arranged by the side of a pad (11) connected to said second power source circuit (VDD) of the semiconductor integrated circuit device.

7. A device according to claim 1, characterized in that said bipolar transistor structure (48) is arranged just under a pad (12) connected to said first power source circuit (GND) of the semiconductor integrated circuit device.

8. A device according to claim 1, characterized in that said bipolar transistor structure (26) is arranged just under a pad (11) connected to said second power source circuit (VDD) of the semiconductor integrated circuit device.

9. A semiconductor integrated circuit device comprising:

a semiconductor substrate (21) of a first conductivity type (N);

a first source region (22) of a second conductivity type (P) formed in said semiconductor substrate (21) and connected to a first power source circuit (VDD) of the semiconductor integrated circuit device;

a first drain region (23) of the second conductivity type (P) formed adjacent to said first source region (22) in said semiconductor substrate (21) and connected to a second power source circuit (GND) of the semiconductor integrated circuit device;

first connection means (25, 27) for connecting said first power source circuit (VDD) to a first base portion of a first bipolar transistor structure (26) formed of said semiconductor substrate (21), first source region (22), and first drain region (23);

a well region (42) of the second conductivity type (P) formed in said semiconductor substrate (21);

a second source region (43) of the first conductivity type (N) formed in said well region (42) and connected to second power source circuit (GND) of the semiconductor integrated circuit device;

a second drain region (44) of the first conductivity type (N) formed adjacent to said second source region (43) in said well region (42) and connected to the first power source circuit (VDD) of the semiconductor integrated circuit device; and

second connection means (46, 49) for connecting said second power source circuit (GND) to a second base portion of a second bipolar transistor structure (48) formed of said well region (42), second source region (43), and second drain region (44).

10. A device according to claim 9, further comprising:

a first gate electrode (24) arranged over a channel region formed between said first source region (22) and first drain region (23) and connected to said first power source circuit (VDD).

11. A device according to claim 9, further comprising:

a second gate electrode (45) arranged over a channel region formed between said second source region (43) and second drain region (44) and connected to said second power source circuit (GND).

12. A device according to claim 9, characterized in that said first bipolar transistor structure (26) is formed near the edge of one of four sides of a rectangular semiconductor chip (200) in which the semiconductor integrated circuit device is formed, and said second bipolar transistor structure (48) is formed near the edge of another one of the four sides of said rectangular semiconductor chip (200).

13. A device according to claim 9, characterized in that said first bipolar transistor structure (26) is formed on one of four corners of a rectangular semiconductor chip (200) in which the semiconductor integrated circuit device is formed, and said second bipolar transistor structure (48) is formed on another one of the four corners of said rectangular semiconductor chip (200).

14. A semiconductor integrated circuit device comprising:

a first node (N1) to which a first power source potential (VDD) is applied;

a second node (N2) to which a second power source potential (GND) is applied; and

a MOS transistor (13 or 14) having drain, source, and gate electrodes, wherein one of said source and drain electrodes is connected to said first node (N1), the other of said source and drain electrodes is connected to said second node (N2), and said gate electrode is connected to said source electrode.

15. A semiconductor integrated circuit device according to claim 14, characterized in that the first power source potential (VDD) is a high potential, the second power source potential (GND) is a low potential, and said MOS transistor is a P channel MOS transistor (13).

16. A semiconductor integrated circuit device according to claim 14, characterized in that the first power source potential (VDD) is a low potential, the second power source potential (GND) is a high potential, and said MOS transistor is an N channel MOS transistor (14).

17. A semiconductor integrated circuit device comprising:

a first node (N1) to which a first power source potential (VDD) is applied;

a second node (N2) to which a second power source potential (GND) is applied;

a P channel MOS transistor (13) having source and gate electrodes connected to said first node (N1) and a drain electrode connected to said second node (N2); and

an N channel MOS transistor (14) having a drain electrode connected to said first node (N1) and source and gate electrodes connected to said second node (N2).

F I G. 1

F I G. 2

F I G. 3

F I G. 4

F I G. 5

F I G. 6

GND    VN    VDD

12    VN    11

45

14

ipan*

70

P⁺    N⁺    N⁺    N⁺

46    icol*    47

43    44

49    48    42

P

N

41

# F I G. 7

N1

11 ~ VDD    S    D    14

G    G

G

12 ~ GND    D    S    13

N2

# F I G. 9

0 276 850

GND

OUT IN

VDD

12

11

45

53

56

57

A

70

70

70

| P+ | N+ | | N+ | N+ | N+ | P+ | | P+ | P+ | | N+ |

46

43

B

44

51

52

55

54

59

14

58

P

42

N

41

# F I G. 8

GND ⚬ ~12

VDD ⚬ ~11

24

45

70

70

icha

icha

P+

N+

N+

P+

ipan

P+

N+

46

43

ipan

23

25

48

icol

22

icol

49

26

27

P

42

N

21

# F I G. 10

GND ⚬ ~12

VDD ⚬ ~11

24

70

45

70

P+

N+

N+

P+

P+

N+

46

43

ipan*

23

25

48

icol*

22

44

ipan*

icol*

26

27

49

P

42

N

21

# F I G. 11

| TERMINAL TO WHICH SURGE IS APPLIED | POLARITY OF SURGE | P-CHANNEL TRANSISTOR 13 | | | N-CHANNEL TRANSISTOR 14 | | |
|---|---|---|---|---|---|---|---|
| | | CHANNEL CURRENT | COLLEC-TOR CURRENT | PUNCH THROUGH CURRENT | CHANNEL CURRENT | COLLEC-TOR CURRENT | PUNCH THROUGH CURRENT |
| VDD | — | ○ | ○ | ○ | ○ | ○ | × |
| VDD | + | × | ○ | × | × | ○ | ○ |
| GND | + | ○ | ○ | × | ○ | ○ | ○ |
| GND | — | × | ○ | ○ | × | ○ | × |

F I G. 12

0 276 850

F I G. 13

F I G. 14

0 276 850

F I G. 15

F I G. 16

F I G. 17

F I G. 18

F I G. 19

F I G. 20

F I G. 21

F I G. 22

F I G. 23

F I G. 24

GND

VDD

43    44

46A  P+    N+    N+    P+    N+

46B   47

42    Pwell    N-SUB

# F I G. 25

GND

VDD

45A    45B

434

43    44

14A    14B

# F I G. 26

GND

VDD

45A  45B

70

P+  N+  N+  N+  P+  N+

46A  43  434  44  46B  47

42

Pwell  N-SUB

# F I G. 27

VDD

14✶

GND

# F I G. 28

GND

VDD

451

70

452

ipan  icha

P+  N+  N+

46  43  44

icol  48✶

P-SUB

# F I G. 29